# EUROPÄISCHE PATENTSCHRIFT

(11) **EP 2 764 340 B1**
(45) Veröffentlichungstag und Bekanntmachung des Hinweises auf die Patenterteilung: **10.10.2018**
(21) Anmeldenummer: 12753420.4
(22) Anmeldetag: 07.08.2012
(51) Int. Cl.: G01L 3/10, G01R 33/02, G01B 7/30

(54) **SENSORANORDNUNG**
SENSOR ARRANGEMENT
ENSEMBLE DE DETECTION

(30) Priorität: 04.10.2011 DE 102011083948
(43) Veröffentlichungstag der Anmeldung: 13.08.2014
(73) Patentinhaber: Robert Bosch GmbH, 70442 Stuttgart (DE)
(72) Erfinder: LUDWIG, Ronny, 72768 Reutlingen (DE)
(86) Internationale Anmeldenummer: PCT/EP2012/065418
(87) Internationale Veröffentlichungsnummer: WO 2013/050192

(56) Entgegenhaltungen:
- AU-B2- 643 046
- JP-A- 9 043 072
- JP-A- 59 063 539

## Beschreibung

Die Erfindung betrifft eine Sensoranordnung und ein Verfahren zum Bestimmen einer relativen Drehung von zwei zueinander koaxial angeordneten Wellen.

### Stand der Technik

Bei Drehmomentsensoren für Wellen kommen heutzutage häufig magnetische Messprinzipien zum Einsatz. Bei derartigen Drehmomentsensoren ist an einer ersten Welle ein Magnetpolring angeordnet. Weiterhin sind an einer zweiten Welle, die zu der ersten Welle koaxial angeordnet ist, zwei weichmagnetische Ringe angeordnet, zwischen denen ein Hall-Sensor angeordnet ist. Bei einer Torsion oder Verdrehung der beiden Wellen relativ zueinander wird ein sich änderndes Magnetfeld des Magnetpolrings zwischen den beiden weichmagnetischen Ringen verstärkt und von dem Hall-Sensor erfasst. Ein Signal des Hall-Sensors wird weiterhin in ein Drehmomentsignal umgerechnet.

Die Druckschrift DE 10 2007 028 481 A1 beschreibt eine derartige Sensoranordnung, die zumindest ein Sensorelement umfasst, das eine Magnetfeldinformation, die auf einer Verdrehung zumindest eines Fluxrings gegenüber einem Magnetpolrad basiert, als Maß für ein Drehmoment und/oder einen Differenzwinkel erfasst. Das hier verwendete Sensorelement weist zudem eine integrierte Schaltung auf.

Andere Sensoranordnungen sind aus den Druckschriften AU 643 046, JP 9 043072 und JP 59 063539 bekannt.

### Offenbarung der Erfindung

Vor diesem Hintergrund werden eine Sensoranordnung und ein Verfahren mit den Merkmalen der unabhängigen Patentansprüche vorgestellt. Weitere Ausgestaltungen der Erfindung ergeben sich aus den abhängigen Patentansprüchen und der Beschreibung.

Mit der Sensoranordnung für zwei Wellen kann eine relative Drehung der beiden Wellen, die zueinander koaxial angeordnet sind, bestimmt werden. Hierzu sind an jeder Welle mehrere Magnetelemente angeordnet, die an der Welle nebeneinander benachbart angeordnet sind. Dabei können Feldlinien von Magnetfeldern benachbarter Magnetelemente in radialer Richtung entlang eines Kreises um eine Drehachse einer Welle in derselben Richtung orientiert sein. An einer Kontaktfläche zwischen den Polen, d. h. zwischen Nord- und Südpol eines Magnetelements und zwischen Nord- und Südpol von zwei benachbarten Magnetelementen, wird ein Polübergang bereitgestellt. Üblicherweise können an jeder Welle mehrere Magnetelemente angeordnet sein, wobei jede Welle dieselbe Anzahl an Magnetelementen aufweist.

Dabei ist jedes Magnetelement als Permanentmagnet ausgebildet, der ein Magnetfeld mit einer fest vorgegebenen Orientierung von Feldlinien des Magnetfelds aufweist. Weiterhin sind die Magnetelemente an den Wellen befestigt. Eine Befestigung eines Magnetelements kann so vorgenommen werden, dass Magnetfeldlinien des Magnetelements an der Welle je nach Definition in axialer Richtung der Welle in Nord-Süd- oder Süd-Nord-Richtung orientiert sind. Durch mehrerer magnetfeldsensitive Messelemente ist es möglich, ein sich überlagerndes Magnetfeld zu erfassen, das aus einem Magnetfeld mehrerer Magnetelemente, die an einer ersten Welle befestigt sind, und einem Magnetfeld mehreren Magnetelemente, die an einer zweiten Welle befestigt sind, resultiert. Wenn sich die beiden Wellen relativ zueinander drehen, verändert sich das resultierende, überlagerte Magnetfeld, so dass aus einer Feldstärke des überlagerten Magnetfelds und/oder einer Richtung oder Orientierung der Feldlinien des überlagerten Magnetfelds ein Maß für die Drehung der Wellen relativ zueinander abgeleitet werden kann.

Eine Anordnung von mehreren Magnetelementen, die als Ringsegmente ausgebildet sein können, an einer Welle wird weiterhin auch als Magnetpolring bezeichnet, wobei definitionsgemäß vorgesehen ist, dass ein derartiger Magnetpolring mindestens ein Magnetelement aufweist. Mehrere Magnetelemente sind auf einem Kreis um die Drehachse der Welle unmittelbar nebeneinander angeordnet. Falls der Magnetpolring mehrere Magnetelemente umfasst, kann sich entlang des Kreises zwischen zwei benachbarten Magnetelementen eine Lücke befinden, so dass sich benachbarter Magnetelemente nicht berühren. In diesem Fall liegt ein sogenannter offener Magnetpolring vor. Es ist auch möglich, dass sich benachbarte Magnetelemente berühren, wobei entlang des Kreises vollständig umlaufend Magnetelemente angeordnet sein können und jedes Magnetelement einen direkten Nachbarn aufweist. In diesem Fall liegt ein sogenannter geschlossener Magnetpolring vor.

Die vorgesehene Sensoranordnung umfasst in Ausgestaltung zwei gleichartige und somit identisch ausgebildete Magnetpolringe, die die Magnetelemente umfassen, wobei jeder Magnetpolring an einer Welle angeordnet ist. Dabei kann ein Magnetpolring als umlaufender Multipol-Magnetring ausgebildet sein. Die beiden Magnetpolringe sind an den beiden Wellen einander gegenüberliegend angeordnet.

In Ausgestaltung kann jeweils ein auf und/oder an einer der beiden Wellen angeordneter Magnetpolring, z. B. als ein kunststoffgebundener Magnet ausgebildet sein, der durch Spritzgießprozesse hergestellt wird, wobei mehrere Magnetelemente miteinander verbunden werden. Ein Magnetpolring kann auf einem Kunststoffträger angeordnet sein, der wiederum auf einer metallischen Hülse, die auf die entsprechende Welle verpresst werden kann, angeordnet ist. Dadurch wird eine exakte Lage der Magnetelemente der beiden Magnetpolringe zueinander in radialer und axialer Richtung unter Einhaltung eines radialen und axialen Abstands zwischen den Magnetelementen erreicht. Beide Magnetpolringe sind bezüglich der Anzahl der Polübergänge und der Magnetisierung der Magnetelemente identisch ausgebildet. Dies kann dadurch erreicht werden, indem beide Magnetpolringe in der gleichen Anlage, also unter exakt identischen Bedingungen, zeitgleich parallel aufmagnetisiert werden.

Eine Anordnung der Magnetelemente und somit der Magnetpolringe zueinander erfolgt so, dass üblicherweise in einer Grundposition der beiden Wellen relativ zueinander, bei der die beiden Wellen zueinander um einen Winkel von 0° gedreht und somit nicht verdreht sind, jeweils bezüglich einer Orientierung der Feldlinien gleiche Pole von Magnetelementen einander gegenüber liegen, d. h. Nordpol zu Nordpol und Südpol zu Südpol. Dadurch ergibt sich, dass sich die durch die Magnetelemente erzeugten Magnetfelder mittig zwischen den beiden Magnetelementen in der Grundposition gegenseitig kompensieren und somit aufheben.

Zwischen den Magnetelementen beider Wellen sind in Ausgestaltung exakt mittig mehrere magnetfeldsensitive Messelemente, z. B mindestens ein Hall-Sensor und/oder mindestens ein AMR-Sensor zur Messung eines anisotropen magnetoresistiven Effekts, angeordnet. Typischerweise ist ein magnetfeldsensitives Messelement auf einer Leiterplatte mit einer weiteren Beschaltung und einem Stecker zur Kontaktierung angeordnet. Die Leiterplatte ist räumlich fixiert und somit im Vergleich zu den drehbaren Wellen fest angeordnet. Die Magnetelemente können sich relativ zu der Leiterplatte und damit zu dem magnetfeldsensitiven Messelement drehen. Dies erlaubt eine Messung einer relativen Drehung der Wellen zueinander von mehr als 360°.

Der Abstand der mehreren Magnetelemente der ersten Welle und der mehreren Magnetelemente der zweiten Welle und somit der beiden Magnetpolringe zueinander kann gering gewählt werden, so dass sich die Magnetfelder der Magnetelemente an den beiden Wellen gegenseitig beeinflussen, wobei die Magnetfelder gekrümmt werden. Im Idealfall ist ein resultierendes Magnetfeld aus den Magnetfeldern der Magnetelemente, die an beiden Wellen angeordnet sind, in der Grundposition exakt in der Mitte zwischen zwei Magnetelementen und/oder zwischen den beiden Magnetpolringen gleich null. Tritt eine Torsion zwischen beiden Wellen auf, werden die Magnetelemente und somit die Magnetpolringe relativ zueinander gedreht. Somit ändert sich das überlagerte Magnetfeld in der Mitte zwischen den Magnetelementen. Dieses in Abhängigkeit der Verdrehung geänderte Magnetfeld kann z. B. mit dem mindestens einen magnetfeldsensitiven Messelement gemessen werden. Das Maß einer Änderung des Magnetfelds ist somit eine Maß für die Drehung der beiden Wellen zueinander.

Um die Eindeutigkeit der Messung zu gewährleisten, ist in Ausgestaltung vorgesehen, dass die maximale Verdrehung der Magnetelemente und/oder beider Magnetpolringe zueinander den Bereich eines Polübergangs zwischen zwei Polen eines Magnetelements und/oder von zwei benachbarten Magnetelementen nicht überschreitet. In der Regel ist vorgesehen, bspw. in Lenkanlagen von Kraftfahrzeugen, eine Torsion im Bereich von +/-4° zu messen. Demnach sind auf einem Umfang jeweils eines Magnetpolrings maximal 44 Magnetelemente und doppelt so viele Polübergänge angeordnet (360°/8°= 45). In einer Ausgestaltung können 16 Magnetelemente und somit 32 Polübergänge pro Magnetpolring vorgesehen sein.
Da sich auch die Richtungen der Feldlinien der Magnetfelder in Abhängigkeit der Verdrehung und Anzahl der Polwechsel zwischen Polen von einem Magnetelement und/oder von zwei benachbarten Magnetelementen auf einer Welle periodisch ändern, bspw. sinus- oder cosinusförmig, können Änderungen der Richtung der Feldkennlinien auch mit mehreren bspw. als Hall- oder AMR-Sensoren ausgebildeten magnetfeldsensitiven Messelementen gemessen und ausgewertet werden.
Eine Feldstärke des im Rahmen der Erfindung zu erfassenden überlagerten Magnetfelds weist in der Regel einen sinus- oder cosinusförmigen Verlauf auf. Dabei befinden sich Maxima und Minima dieses sinus- oder cosinusförmigen Verlaufs zwischen gleichen Polen, d. h. zwischen zwei Südpolen oder zwei Nordpolen, wobei jeweils ein Pol als Komponente eines Magnetelements an einer der beiden Wellen angeordnet ist. Ein Nulldurchgang und somit eine sogenannte Sinus- oder Cosinusflanke des Verlaufs des überlagerten Magnetfelds befindet sich in der Regel zwischen zwei Polübergängen, wobei jeweils ein Polübergang an einer Welle angeordnet ist und durch einen Grenzbereich von zwei benachbarten, unterschiedlichen Polen, d. h. zwischen einem Nordpol und einem Südpol gebildet wird. Eine Steilheit der Sinusflanke in dem Nulldurchgang einer Sinusfunktion, die zu einer Änderung des resultierenden Magnetfelds weitgehend proportional ist, ist hier ein Maß für eine Verdrehung der Wellen zueinander.
Da in den Minima und Maxima der Sinusfunktion eine relative Änderung des resultierenden Magnetfelds sehr gering bis null ist, ist in Ausgestaltung der Erfindung bspw. eine rotationssymmetrische Anordnung von mehreren magnetfeldsensitiven Messelementen vorgesehen, deren Periodizität sich von einer Periodizität der Magnetpolringe unterscheidet. Auch die Kombination von mindestens einem Hall-Sensor und mindestens einem AMR-Sensor zur Messung der Feldänderung ist denkbar. Somit kann parallel sowohl die Feldstärke als auch die Feldrichtung des resultierenden Magnetfelds gemessen werden. Weiterhin ist es möglich, bei geeigneter Anordnung der magnetfeldsensitiven Messelemente auch eine Richtung der Verdrehung der Wellen zueinander zu bestimmen. Üblicherweise kann mit der Sensoranordnung eine relativ Messung einer Torsion und somit eines Drehmoments zwischen beiden Wellen realisiert werden, die üblicherweise über einen Torsionsstab miteinander verbunden sind.

Die Sensoranordnung kann in sehr kompakter Bauform unter sehr geringem Platzbedarf, vor allem in der axialen Bauhöhe, mit einer axialen Höhe von weniger als 20 mm realisiert werden. Im Unterschied zu bekannten, vergleichsweise aufwendigen Konstruktionen zur Drehmomenterfassung können flussleitende Ringe aus weichmagnetischem Material, bspw. NiFe-Blech, als Magnetflusssammler entfallen. Da beide Magnetpolringe als exakt gleiche Bauteile ausgebildet sind, können durch erhöhte Stückzahlen Herstellungskosten reduziert werden. Außerdem ist eine relativ einfache Aufbau- und Verbindungstechnik vorgesehen sowie ein verschleißfreies Messen möglich. Mit der Erfindung kann eine Alternative zu herkömmlichen Drehmomentsensoren bereitgestellt werden. Weiterhin sind bei geringem Abstand zwischen beiden Magnetpolringen lediglich schwache Magnetfelder erforderlich. Dies erlaubt die Verwendung von Ferriten als Magnetmaterial, wodurch auf seltene Erden, wie bspw. SmCo oder NdFeB, verzichtet werden kann.

Die erfindungsgemäße Sensoranordnung ist dazu ausgebildet, sämtliche Schritte des vorgestellten Verfahrens durchzuführen. Dabei können einzelne Schritte dieses Verfahrens auch von einzelnen Komponenten der Sensoranordnung durchgeführt werden. Weiterhin können Funktionen der Sensoranordnung oder Funktionen von einzelnen Komponenten der Sensoranordnung als Schritte des Verfahrens umgesetzt werden. Außerdem ist es möglich, dass Schritte des Verfahrens als Funktionen wenigstens einer Komponente der Sensoranordnung oder der gesamten Sensoranordnung realisiert werden.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Kurze Beschreibung der Zeichnungen
- Figur 1: zeigt in schematischer Darstellung eine erste Ausführungsform der erfindungsgemäßen Sensoranordnung für zwei gegenüberliegende Wellen.
- Figur 2: zeigt die Sensoranordnung aus Figur 1 in schematischer Schnittdarstellung.
- Figur 3: zeigt die Sensoranordnung aus Figur 1 aus einer weiteren Perspektive.
- Figur 4: zeigt die Sensoranordnung aus Figur 1 in schematischer Schnittdarstellung sowie ein erstes schematisch dargestelltes Detail dieser Sensoranordnung.
- Figur 5: zeigt in schematischer Darstellung ein zweites Detail der Sensoranordnung aus Figur 1 bei einer Durchführung einer Ausführungsform des erfindungsgemäßen Verfahrens.
- Figur 6: zeigt in schematischer Darstellung ein drittes Detail der Anordnung aus Figur 1 bei einer Ausführungsform des erfindungsgemäßen Verfahrens.
- Figur 7: zeigt in schematischer Darstellung eine beispielhafte, nicht beanspruchte Sensoranordnung.
- Figur 8: zeigt in schematischer Darstellung ein Beispiel eines aus dem Stand der Technik bekannten Drehmomentsensors.
- Figur 9: zeigt erste Details des Drehmomentsensors aus Figur 8 in schematischer Darstellung.
- Figur 10: zeigt in schematischer Darstellung zweite Details des Drehmomentsensors aus Figur 8.

### Ausführungsformen der Erfindung

Die Erfindung ist anhand von Ausführungsformen in den Zeichnungen schematisch dargestellt und wird nachfolgend unter Bezugnahme auf die Zeichnungen ausführlich beschrieben.

Die Figuren werden zusammenhängend und übergreifend beschrieben, gleiche Bezugszeichen bezeichnen gleiche Komponenten.

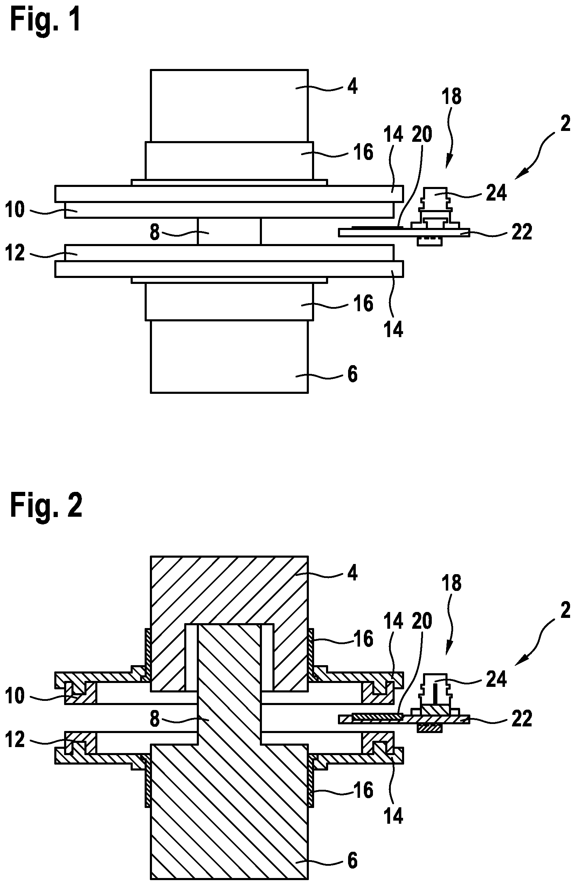

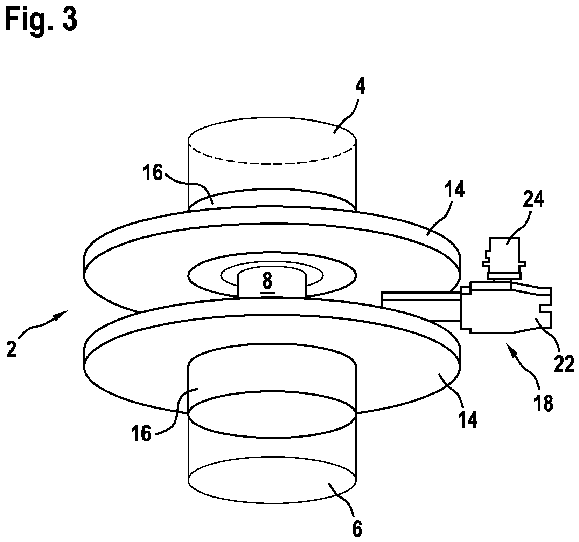

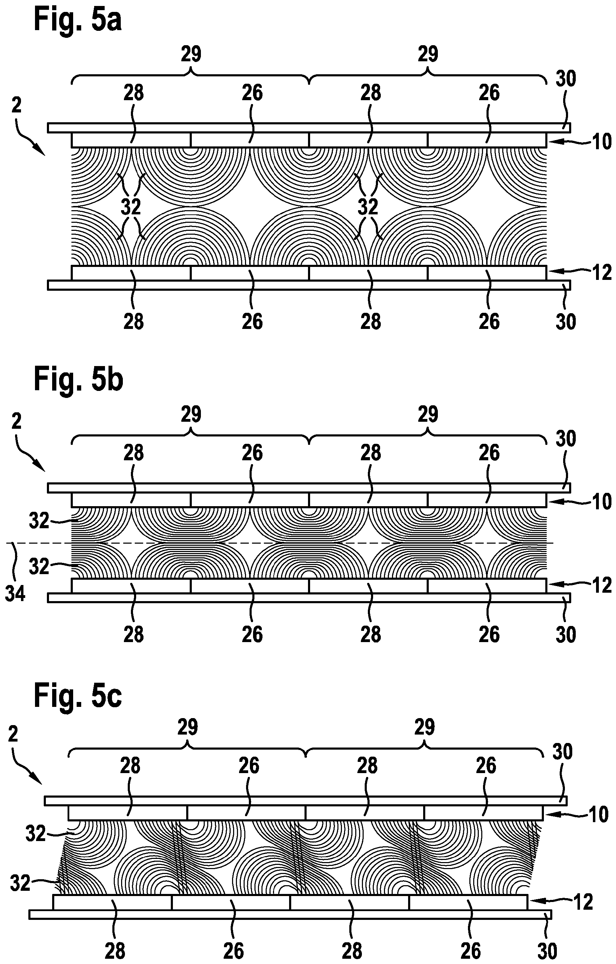

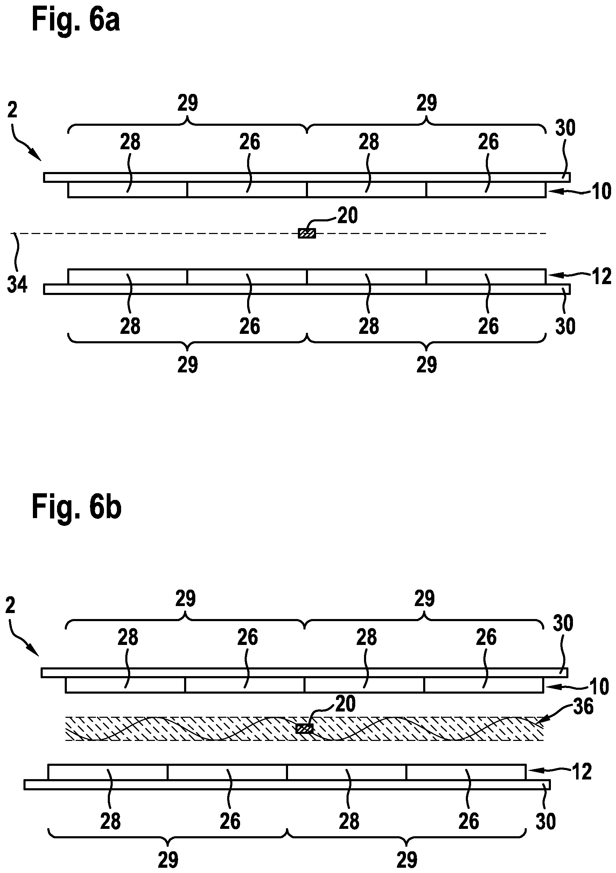

Die in den Figuren 1 bis 4 aus verschiedenen Perspektiven und/oder in verschiedenen Darstellungen schematisch gezeigte erste Ausführungsform der erfindungsgemäßen Sensoranordnung 2 sowie Details dieser Sensoranordnung 2, die in den Figuren 5 und 6 bei einer Ausführung des erfindungsgemäßen Verfahrens schematisch dargestellt sind, ist dazu ausgebildet, eine Drehung einer ersten Welle 4 und einer zweiten Welle 6, die zueinander koaxial angeordnet und über einen Torsionsstab 8 miteinander verbunden sind, zu bestimmen.

Dabei umfasst die Sensoranordnung 2 eine erste Anordnung von Magnetelementen, die an der ersten Welle 4 drehfest angeordnet sind. Diese Anordnung von ersten Magnetelementen an der ersten Welle 4 wird weiterhin als ein erster Magnetpolring 10 bezeichnet. Analog ist an der zweiten Welle 6 eine zweite Anordnung von zweiten Magnetelementen vorgesehen, die an dieser zweiten Welle 6 ebenfalls drehfest angeordnet sind, wobei diese zweite Anordnung von zweiten Magnetelementen als zweiter Magnetpolring 12 bezeichnet wird. Jeweils ein Magnetpolring 10, 12 ist hier über einen Kunststoffträger 14 sowie eine Hülse 16 an der jeweiligen Welle 4, 6 drehfest befestigt.

Weiterhin umfasst die Sensoranordnung 2 eine Messanordnung 18, die ein magnetfeldsensitives Messelement 20 umfasst. Dieses magnetfeldsensitive Messelement 20 kann bspw. als Hall- oder AMR-Sensor ausgebildet sein. Es ist vorgesehen, dass das magnetfeldsensitive Messelement 20 in axialer Richtung der beiden Wellen 4, 6 genau mittig zwischen den gegenüberliegenden Magnetpolringen 10, 12 bezüglich der beiden Wellen 4, 6 an einem hier nicht gezeigten Bauteil drehfest angeordnet ist.

Somit ist es möglich, mit dem magnetfeldsensitiven Messelement 20 ein überlagertes Magnetfeld, das sich aus einem ersten Magnetfeld der ersten Magnetelemente, die an der ersten Welle 4 angeordnet sind und aus einem zweiten Magnetfeld der zweiten Magnetelemente, die an der zweiten Welle 6 angeordnet sind, ergibt, zu erfassen.

Die Messanordnung 18 umfasst weiterhin eine Leiterplatte 22, an der das magnetfeldsensitive Messelement 20 angeordnet ist. Weiterhin ist an der Leiterplatte 22 ein Stecker 24 angeordnet, über den Signale des magnetfeldsensitiven Messelements 20 an eine Auswerteeinrichtung übermittelt werden können.

Üblicherweise können sich die beiden Wellen 4, 6 auch unabhängig voneinander relativ zu einer gemeinsamen Drehachse drehen, wobei der Torsionsstab 8 verdrillt wird, woraus ein Drehmoment zwischen den beiden Wellen 4, 6 resultiert. Außerdem können sich die beiden Wellen 4, 6 relativ zu dem hier nicht gezeigten Bauteil drehen, wobei das magnetfeldsensitive Messelement 20 über die Leiterplatte 22 und/oder den Stecker 24 an diesem Bauteil drehfest befestigt ist, so dass sich die beiden Wellen 4, 6 relativ zu dem magnetfeldsensitiven Messelement 20 drehen können.

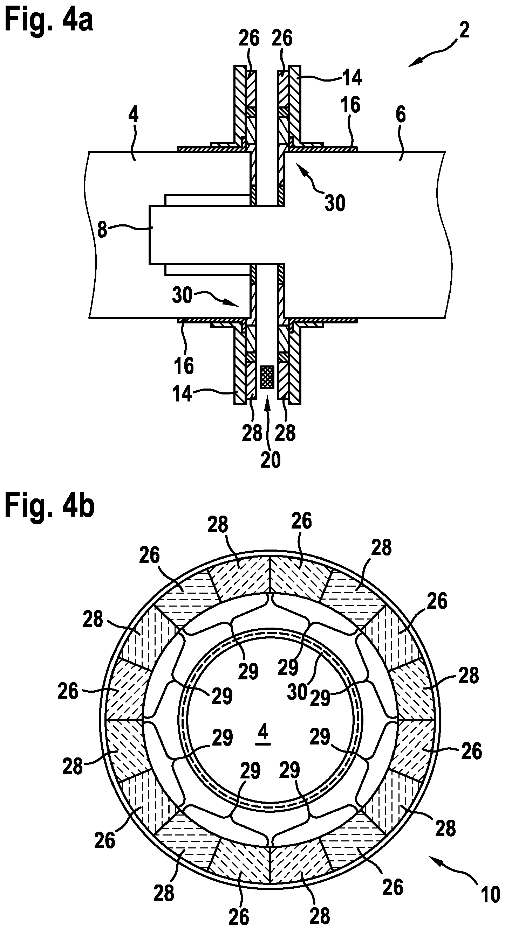

In der schematischen Darstellung in Figur 4 sind Südpole 26 und Nordpole 28 der einzelnen Magnetelemente 29 der beiden Magnetpolringe 10, 12 mit dem zwischen den Magnetelementen 29 räumlich fixierten magnetfeldsensitiven Messelement 20 in Schnittdarstellung (Figur 4a) sowie in Draufsicht (Figur 4b) schematisch dargestellt, wobei Figur 4b ohne Beschränkung der Allgemeinheit den ersten Magnetpolring 10 zeigt, der bei der hier gezeigten Ausführungsform der Erfindung identisch wie der zweite Magnetpolring 12 ausgebildet ist. Weiterhin zeigt Figur 4 Details zu einem Trägerelement 30, über den die Magnetelemente 29 mit dem Kunststoffträger 14 und/oder der Hülse 16 und somit mit einer der beiden Wellen 4, 6 drehfest verbunden sind.

Wie Figur 4b zeigt, sind die einzelnen Magnetelemente 29 als Ringsegmente des ersten Magnetpolrings 10 und somit auch des zweiten Magnetpolrings 12 ausgebildet. Zwei benachbarte Magnetelemente 29 sind an einer Welle 4, 6 unter gleichartig orientierten Feldlinien nebeneinander angeordnet, so dass die Feldlinien unmittelbar benachbarter Magnetelemente 29 abwechselnd entweder in Nord-Süd-Richtung oder Süd-Nord-Richtung orientiert sind. Weiterhin ergeben sich zwischen zwei benachbarten Südpolen 26 und Nordpolen 28 eines Magnetelements 29 und/oder von benachbarten Magnetelementen 29 Polübergänge.

Die beiden Magnetpolringe 10, 12 sind in der beschriebenen Ausführungsform bezüglich der Anzahl der Polübergänge und einer Genauigkeit der Magnetisierung absolut identisch ausgebildet. Dabei ist in Figur 4b beispielhaft ein Magnetpolring 10 mit 16 Polübergängen dargestellt.

Figur 5 zeigt ein Funktionsprinzip der Sensoranordnung 2 mit zwei Magnetpolringen 10, 12, von denen jeweils ein Ausschnitt, idealisiert in einer Ebene, schematisch dargestellt ist. In der Grundposition stehen sich gleiche Pole, d. h. Südpole 26 und Nordpole 28 von Magnetelementen 29 beider Magnetpolringe 10, 12 gegenüber. Somit sind jeweils Südpole 26 und Nordpole 28 gegenüberliegend angeordnet (Figur 5a). Ist der Abstand beider Magnetpolringe 10, 12 zueinander so klein, dass sich die Magnetfelder 32 gegenüberliegender Magnetelemente 29 gegenseitig beeinflussen, werden diese Magnetfelder 32 entsprechend gekrümmt (Figur 5b). Üblicherweise ist das Magnetfeld somit exakt in der Mitte (gestrichelte Linie 34) zwischen beiden Magnetpolringen 10, 12 gleich null. Werden die Magnetpolringe 10, 12 relativ zueinander gedreht oder, wie in Figur 5c schematisch dargestellt, zueinander verschoben, so ändert sich das resultierende, überlagerte Magnetfeld in der Mitte zwischen beiden Magnetpolringen 10, 12. Dieses geänderte Magnetfeld kann z. B. mit dem magnetfeldsensitiven Messelement 20 gemessen werden. Das Maß der Änderung des überlagerten resultierenden Magnetfelds ist somit ein Maß für die Drehung der Wellen 4, 6 relativ zueinander.

Da sich auch die Feldrichtungen der Magnetfelder 32 in Abhängigkeit der Verdrehung und Anzahl der Polübergänge oder Polwechsel zwischen benachbarten Polen, d. h. Süd- und Nordpolen 26, 28 einer Welle 4, 6 periodisch, bspw. sinusförmig, ändern, kann die Änderung der Feldrichtung auch mit mehreren AMR-Sensoren gemessen und ausgewertet werden. Die Steilheit der Sinusflanken ist hier ein Maß für die relative Drehung. Da in den Maxima und Minima der Sinusfunktion die relative Änderung der Magnetfelder 32 sehr gering bis null ist, ist für diesen Fall die Anordnung von mehreren AMR-Sensoren mit einer anderen Periodizität als eine Periodizität der Pole der Magnetpolringe 10, 12 vorgesehen.

In Figur 6 ist die erfindungsgemäße Anordnung entsprechend der Darstellung aus Figur 5 schematisch dargestellt, wobei auf die Darstellung der Magnetfelder 32 verzichtet wird. Stattdessen ist in Figur 6 genau in der Mitte zwischen den Magnetelementen 29 sowie Süd- und Nordpolen 26, 28 der beiden Wellen 10, 12 und somit genau in der Mitte zwischen den beiden Magnetpolringen 10, 12 das magnetfeldsensitive Messelement 20 dargestellt. Hierbei befindet sich die Sensoranordnung 2 in Figur 6a, entsprechend der Darstellung aus den Figuren 5a und 5b, in der sogenannten Grundposition, die derart definiert ist, dass die beiden Wellen 4, 6 und somit die Magnetpolringe 10, 12 gegenseitig nicht verdreht und somit um einen Winkel von 0° gegeneinander gedreht sind. In diesem Fall sind gleichartige Pole, d. h. Südpole 26 und Nordpole 28 der beiden gegenüberliegenden Magnetpolringe 10, 12, deren Feldlinien in dieselbe Richtung orientiert sind, einander exakt gegenüberliegend angeordnet.

Figur 6b zeigt die Sensoranordnung 2 bei einer geringen Drehung der beiden Wellen 4, 6 zueinander, woraus auch eine Drehung der an den beiden Wellen angeordneten Süd- und Nordpole 26, 28 sowie der Magnetpolringe 10, 12 resultiert. Durch die Drehung der Wellen 4, 6 zueinander um die gemeinsame Drehachse ergibt sich eine sinusförmige Änderung des durch die Magnetfelder 32 der Magnetelemente 29 resultierenden, überlagerten Magnetfelds, wobei eine Änderung einer Feldstärke des resultierenden Magnetfelds in Figur 6b hier durch eine Sinuskurve 36 angedeutet ist.

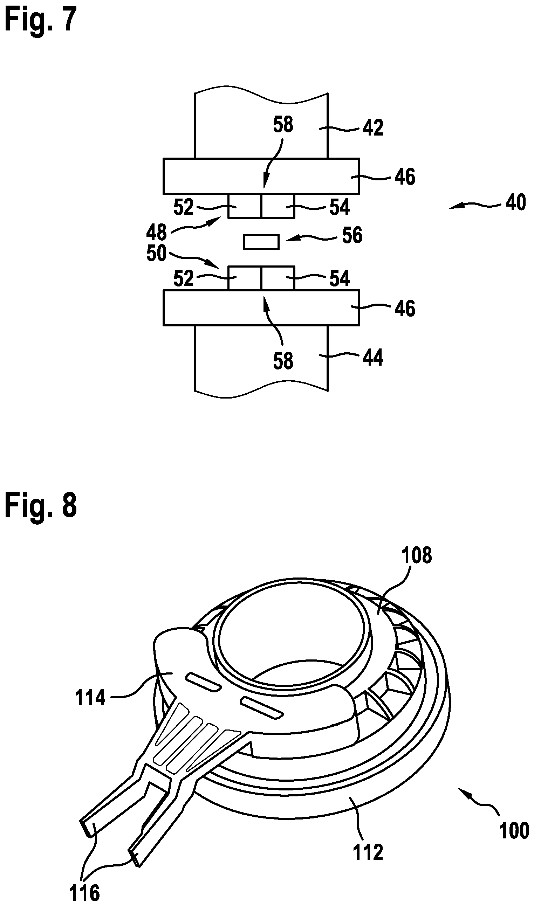

In Figur 7 ist eine beispielhafte, nicht beanspruchte Sensoranordnung 40 schematisch dargestellt. Mit dieser Sensoranordnung 40 ist es ebenfalls möglich, eine relative Drehung einer ersten Welle 42 und einer zweiten Welle 44, die zueinander koaxial angeordnet sind, zu bestimmen. An jeder Welle 42, 44 sind Trägerelemente 46 angeordnet, an denen wiederum als Ringsegmente ausgebildete Magnetelemente 48, 50, mit einem Südpol 52 und einem Nordpol 54 angeordnet und somit an den Wellen 42, 44 befestigt sind.

Im Unterschied zu der ersten Ausführungsform der erfindungsgemäßen Sensoranordnung, bei der an jeder Welle 4, 6 ein Magnetpolring 10, 12 mit durchgehend umlaufenden Magnetelementen 29 angeordnet ist, weist die in Figur 7 gezeigte Sensoranordnung 40 an jeder Welle 42, 44 jeweils nur ein Magnetelement 48, 50 auf. Dabei ist ein erstes Magnetelement 48 an der ersten Welle 42 angeordnet. An der zweiten Welle 44 ist ein zweites Magnetelement 50 angeordnet. Als weitere Komponente der Sensoranordnung 40 ist in Figur 7 in axialer Richtung der beiden Wellen 42, 44 zwischen den Magnetelementen 48, 50 ein magnetfeldsensitives Messelement 56 angeordnet.

Außerdem ist in Figur 7 die Sensoranordnung 40 in einer sogenannten Grundposition dargestellt. Dabei ist vorgesehen, dass der Südpol 52 des ersten Magnetelements 48 an der ersten Welle 42 dem Südpol 52 des Magnetelements 50 an der zweiten Welle 44 gegenüberliegt. Außerdem ist der Nordpol 54 des ersten Magnetelements 48 gegenüber dem Nordpol 54 des zweiten Magnetelements 50 angeordnet. Weiterhin weist jedes Magnetelement 48, 50 zwischen Süd- und Nordpol 52, 54 einen Polübergang 58 auf, wobei diese Polübergänge 58 in der dargestellten Grundposition ebenfalls gegenüberliegend angeordnet sind. Das magnetfeldsensitive Messelement 56 ist in der Grundposition zwischen den zwei Polübergängen 58 angeordnet.

Von dem magnetfeldsensitiven Messelement 56 in der Mitte zwischen den Magnetelementen 48, 50 wird bei einer Durchführung des erfindungsgemäßen Verfahrens ein überlagertes Magnetfeld gemessen und somit erfasst, das sich durch Überlagerung der Magnetfelder des Magnetelements 48 an der ersten Welle 42 sowie des Magnetelements 50 an der zweiten Welle 44 ergibt. Befinden sich die Wellen 42, 44 und somit auch die Sensoranordnung 40 in der Grundposition, wie anhand von Figur 7 schematisch dargestellt, so ist das resultierende Magnetfeld in der Mitte zwischen den Magnetelementen 48, 50 der beiden Wellen 42, 44 null. Falls sich die beiden Wellen 42, 44 relativ zueinander drehen, ändert sich auch das überlagerte Magnetfeld, wobei aus einer Änderung dieses überlagerten Magnetfelds ein Winkel für die Drehung der beiden Wellen 42, 44 relativ zueinander abgeleitet wird.

Mit der vorgestellten Ausführungsform der Sensoranordnung 2, ist ein Verfahren zum Bestimmen einer relativen Drehung von zwei zueinander koaxial angeordneten Wellen 4, 6 durchführbar. Die Sensoranordnung 2, umfasst mehrere an einer ersten Welle 4, angeordnete Magnetelemente 29, mehrere an einer zweiten Welle angeordnete Magnetelemente 29, sowie mehrere magnetfeldsensitive Messelemente 20, die ortsfest zwischen den Magnetelementen 29, der beiden Wellen 4, 6, angeordnet sind, wobei von den mehreren magnetfeldsensitiven Messelementen 20, ein sich aus einer Überlagerung der Magnetfelder 32 der Magnetelemente 29, beider Wellen 4, 6, ergebendes Magnetfeld erfasst wird.

Dabei können Pole, d. h. Süd- und Nordpole 26, 28, 52, 54, an einer Welle 4, 6, 42, 44 in radialer Richtung nebeneinander abwechselnd angeordnet sein. Demnach grenzt zwischen zwei benachbarten Magnetelementen 29, 48, 50, die an einer Welle 40, 42, 44 angeordnet sind, in radialer Richtung ein Südpol 26, 52 an einem Nordpol 28, 54. Zwischen zwei sich berührenden Magnetelementen 29, 48, 50 und/oder zwischen zwei unterschiedlichen Polen, d. h. zwischen einem Südpol 26, 52 und einem Nordpol 28, 54 wird ein Polübergang 58 bereitgestellt. An jeder Welle 4, 6, 42, 44 ist dieselbe Anzahl an Magnetelementen 29, 48, 50 angeordnet, wobei ein Magnetfeld 32 jedes Magnetelements 29, 48, 50 betragsmäßig dieselbe Feldstärke und Feldrichtung aufweist.

Für die Sensoranordnung 2, 40 kann eine Grundposition definiert sein, für die vorgesehen ist, dass die beiden Wellen 4, 6, 42, 44 relativ zueinander um 0° gedreht sind, wobei entlang eines radialen Umfangs beider Wellen an einer Winkelposition von x° an der ersten Welle 4, 42 und an der zweiten Welle 6, 44 gleiche Pole, d. h. entweder Südpole 26, 52 oder Nordpole 28, 54, angeordnet sind. Die mehreren magnetfeldsensitiven Messelemente 20 sind in axialer Richtung der Welle 4, 6, 42, 44 in der Regel genau mittig zwischen den Magnetelementen 29, 48, 50 angeordnet. Außerdem kann das mindestens eine magnetfeldsensitive Messelement 20, 56 in der Grundposition der Sensoranordnung 2, 40 in axialer Richtung der Wellen 4, 6, 42, 44 zwischen zwei Polübergängen 58, die an den beiden Wellen 4, 6, 42, 44 angeordnet sind, angeordnet sein.

Eine relative Drehung der beiden Wellen 4, 6, 42, 44 zueinander kann aus einer Änderung des Magnetfelds, das sich aus der Überlagerung der Magnetfelder 32 der Magnetelemente 29, 48, 50 beider Wellen 4, 6, 42, 44 ergibt, abgeleitet werden.

Eine Sensoranordnung 2, 40 kann eine beliebige Anzahl an magnetfeldsensitiven Messelementen 20, 56 aufweisen. Dabei sind mehrere derartige magnetfeldsensitive Messelemente 20, 56 auf einem Kreis um die gemeinsame Drehachse beider Wellen 4, 6, 42, 44 üblicherweise unter gleichen Winkelabständen zueinander angeordnet. Falls bspw. k magnetfeldsensitive Messelemente 20, 56 vorgesehen sind, so beträgt ein Winkelabstand zwischen zwei magnetfeldsensitiven Messelementen 20, 56 360°/k. Außerdem können zwei Polübergänge 58, die an gegenüberliegenden Wellen 4, 6, 42, 44 angeordnet sind, ebenfalls in einem Winkelabstand von 360°/k beabstandet sein.

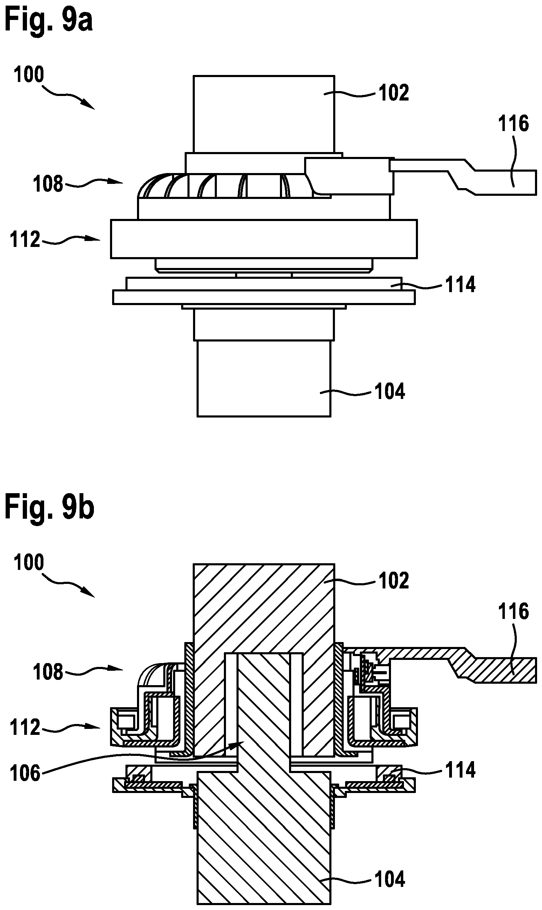

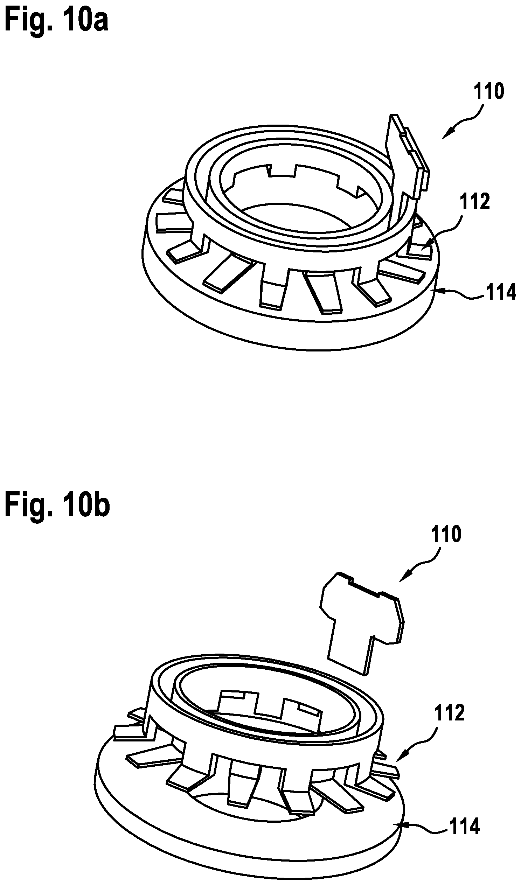

Der in den Figuren 8 bis 10 schematisch dargestellte, aus dem Stand der Technik bekannte Drehmomentsensor 100 ist zum Bestimmen eines Drehmoments zwischen einer ersten und einer zweiten Welle 102, 104, die über einen Torsionsstab 106 miteinander verbunden sind, ausgebildet. Dieser Drehmomentsensor 100 umfasst eine Sensoreinheit 108 mit einem magnetfeldsensitiven Sensorelement 110, eine Magnetflusseinheit 112, die hier an der ersten Welle 102 befestigt ist, sowie einen Magnetpolring 114, der an der zweiten Welle 104 befestigt ist. Hier ist die Sensoreinheit 108 über ein Befestigungselement 114, das Befestigungsarme 116 aufweist, an einem nicht weiter dargestellten Bauteil befestigt, zu dem sich die beiden Wellen 102, 104 drehen können. Dabei wird ein Magnetfeld, das von dem Magnetpolring 114 erzeugt wird, durch die Magnetflusseinheit 112 an der ersten Welle 102 verstärkt, wobei das verstärkte Magnetfeld von der Sensoreinheit 108 erfasst wird.

## Patentansprüche

1. Sensoranordnung zum Bestimmen einer relativen Drehung von zwei zueinander koaxial angeordneten Wellen (4, 6), die mehrere an einer ersten Welle (4) angeordnete Magnetelemente (29) und mehrere an einer zweiten Welle (6) angeordnete Magnetelemente (29) umfasst, wobei die Magnetelemente (29), die an der ersten Welle (4) angeordnet sind, einen ersten Magnetpolring (10) und die Magnetelemente (29), die an der zweiten Welle (6) angeordnet sind, einen zweiten Magnetpolring (12) bilden,
wobei die Sensoranordnung (2) mehrere magnetfeldsensitive Messelemente (20) umfasst, die ortsfest zwischen den Magnetelementen (29) der beiden Wellen (4, 6) angeordnet sind und dazu eingerichtet sind, ein Magnetfeld zu erfassen, das sich aus einer Überlagerung der Magnetfelder (32) der Magnetelemente (29) beider Wellen (4, 6) ergibt, **dadurch gekennzeichnet, dass**
die mehreren magnetfeldsensitiven Messelemente (20) auf einem Kreis um die gemeinsame Drehachse beider Wellen (4, 6) unter gleichen Winkelabständen zueinander angeordnet sind, wobei sich die Periodizität einer rotationssymmetrischen Anordnung der magnetfeldsensitiven Messelemente (20) von der Periodizität der Magnetpolringe (10, 12) unterscheidet.

2. Sensoranordnung nach Anspruch 1, bei der an jeder Welle (4, 6, 42, 44) Pole der Magnetelemente (29, 48, 50) in radialer Richtung orientiert angeordnet sind.

3. Sensoranordnung nach Anspruch 1 oder 2, bei der sich zwei an einer Welle (4, 6, 42, 44) nebeneinander angeordnete Magnetelemente (29, 48, 50) gegenseitig berühren und einen Polübergang (58) bereitstellen.

4. Sensoranordnung nach einem der voranstehenden Ansprüche, bei der jede Welle (4, 6, 42, 44) dieselbe Anzahl an Magnetelementen (29, 48, 50) aufweist, wobei ein Magnetfeld (32) jedes Magnetelements (29, 48, 50) dieselbe Feldstärke und Feldrichtung aufweist.

5. Sensoranordnung nach einem der Ansprüche 2 bis 4, für die eine Grundposition definiert ist, für die vorgesehen ist, dass die beiden Wellen (4, 6, 42, 44) relativ zueinander um 0° gedreht sind, wobei entlang eines radialen Umfangs beider Wellen (4, 6, 42, 44) an einer Winkelposition von x° an der ersten Welle (4) und an der zweiten Welle (6) gleiche Pole angeordnet sind.

6. Sensoranordnung nach einem der voranstehenden Ansprüche, bei der die magnetfeldsensitiven Messeelemente (20, 56) in axialer Richtung der beiden Wellen (4, 6, 42, 44) in der Mitte zwischen den an den beiden Wellen (4, 6, 42, 44) angeordneten Magnetelementen (29, 48, 50) angeordnet sind.

7. Verfahren zum Bestimmen einer relativen Drehung von zwei zueinander koaxial angeordneten Wellen (4, 6) mit einer Sensoranordnung (2), die mehrere an einer ersten Welle (4) angeordnete Magnetelemente (29) und mehrere an einer zweiten Welle (6) angeordnete Magnetelemente (29) umfasst, wobei die Magnetelemente (29), die an der ersten Welle (4) angeordnet sind, einen ersten Magnetpolring (10) und die Magnetelemente (29), die an der zweiten Welle (6) angeordnet sind, einen zweiten Magnetpolring (12) bilden,
wobei die Sensoranordnung (2) mehrere magnetfeldsensitive Messelemente (20) umfasst, die ortsfest zwischen den Magnetelementen (29) der beiden Wellen (4, 6) angeordnet sind, **dadurch gekennzeichnet, dass** die mehreren magnetfeldsensitiven Messelemente (20) auf einem Kreis um die gemeinsame Drehachse beider Wellen (4, 6) unter gleichen Winkelabständen zueinander angeordnet sind, wobei sich die Periodizität einer rotationssymmetrischen Anordnung der magnetfeldsensitiven Messelemente (20) von der Periodizität der Magnetpolringe (10, 12) unterscheidet, wobei von den Messelementen (20) ein sich aus einer Überlagerung der Magnetfelder (32) der Magnetelemente (29) beider Wellen (4, 6) ergebendes Magnetfeld erfasst wird.

8. Verfahren nach Anspruch 7, bei dem die relative Drehung der beiden Wellen (4, 6, 42, 44) zueinander aus einer Änderung des Magnetfelds, das sich aus der Überlagerung der Magnetfelder (32) der Magnetelemente (29, 48, 50) beider Wellen (4, 6, 42, 44) ergibt, abgeleitet wird.

## Claims

1. Sensor arrangement for determining a relative rotation of two shafts (4, 6) arranged coaxially with respect to one another, said sensor arrangement comprising a plurality of magnetic elements (29) arranged on a first shaft (4) and a plurality of magnetic elements (29) arranged on a second shaft (6), wherein the magnetic elements (29) arranged on the first shaft (4) form a first magnetic pole ring (10) and the magnetic elements (29) arranged on the second shaft (6) form a second magnetic pole ring (12), wherein the sensor arrangement (2) comprises a plurality of magnetic field-sensitive measuring elements (20) that are arranged in a spatially fixed manner between the magnetic elements (29) of the two shafts (4, 6) and are set up to detect a magnetic field that occurs as a result of a superposition of the magnetic fields (32) of the magnetic elements (29) of the two shafts (4, 6), **characterized in that** the plurality of magnetic field sensitive measuring elements (20) are arranged in a circle around the common axis of rotation of the two shafts (4, 6) at identical angular spacings with respect to one another, wherein the periodicity of a rotationally symmetrical arrangement of the magnetic field-sensitive measuring elements (20) differs from the periodicity of the magnetic pole rings (10, 12).

2. Sensor arrangement according to Claim 1, in which poles of the magnetic element (29, 48, 50) are arranged on each shaft (4, 6, 42, 44) in such a manner that they are aligned in the radial direction.

3. Sensor arrangement according to Claim 1 or 2, in which two magnetic elements (29, 48, 50) that are arranged next to one another on a shaft (4, 6, 42, 44) contact one another and provide a pole transition (58).

4. Sensor arrangement according to any one of the preceding claims, in which each shaft (4, 6, 42, 44) comprises an identical number of magnetic elements (29, 48, 50), wherein a magnetic field (32) of each magnetic element (29, 48, 50) comprises the identical values of field strength and field direction.

5. Sensor arrangement according to any one of Claims 2 to 4, for which an initial position is defined, for which it is provided that the two shafts (4, 6, 42, 44) are rotated relative to one another about 0°, wherein identical poles are arranged along a radial circumference of the two shafts (4, 6, 42, 44) at an angular position of x° on the first shaft (4) and on the second shaft (6).

6. Sensor arrangement according to any one of the preceding claims, in which the magnetic field-sensitive measuring elements (20, 56) are arranged in the axial direction of the two shafts (4, 6, 42, 44) midway between the magnetic elements (29, 48, 50) that are arranged on the two shafts (4, 6, 42, 44).

7. Method for determining a relative rotation of two shafts (4, 6) arranged coaxially with respect to one another with a sensor arrangement (2) comprising a plurality of magnetic elements (29) arranged on a first shaft (4) and a plurality of magnetic elements (29) arranged on a second shaft (6), wherein the magnetic elements (29) arranged on the first shaft (4) form a first magnetic pole ring (10) and the magnetic elements (29) arranged on the second shaft (6) form a second magnetic pole ring (12), wherein the sensor arrangement (2) comprises a plurality of magnetic field-sensitive measuring elements (20) that are arranged in a spatially fixed manner between the magnetic elements (29) of the two shafts (4, 6), **characterized in that** the plurality of magnetic field-sensitive measuring elements (20) are arranged in a circle around the common axis of rotation of the two shafts (4, 6) at identical angular spacings with respect to one another, wherein the periodicity of a rotationally symmetrical arrangement of the magnetic field-sensitive measuring elements (20) differs from the periodicity of the magnetic pole rings (10, 12), wherein a magnetic field that results from a superposition of the magnetic fields (32) of the magnetic elements (29) of the two shafts (4, 6) is detected by the measuring elements (20).

8. Method according to Claim 7, in which the relative rotation of the two shafts (4, 6, 42, 44) is deduced from a change of the magnetic field that occurs as a result of the superposition of the magnetic fields (32) of the magnetic elements (29, 48, 50) of the two shafts (4, 6, 42, 44).

## Revendications

1. Système de capteur destiné à déterminer une rotation relative de deux arbres (4, 6) disposés de manière coaxiale l'un par rapport à l'autre, lesquels arbres comprennent une pluralité d'éléments magnétiques (29) disposés sur un premier arbre (4) et une pluralité d'éléments magnétiques (29) disposés sur un deuxième arbre (6),
dans lequel les éléments magnétiques (29) qui sont disposés sur le premier arbre (4) forment un premier anneau polaire magnétique (10) et les éléments magnétiques (29) qui sont disposés sur le deuxième arbre (26) forment un deuxième anneau polaire magnétique (12),
dans lequel le système de capteur (2) comprend plusieurs éléments de mesure sensibles au champ magnétique (20) qui sont disposés en position fixe entre les éléments magnétiques (29) des deux arbres (4, 6) et qui sont conçus pour détecter un champ magnétique résultant d'une superposition des champs magnétiques (32) des éléments magnétiques (29) des deux arbres (4, 6), **caractérisé en ce que** la pluralité d'éléments de mesure sensibles au champ magnétique (20) sont disposés sur un cercle entourant l'axe de rotation commun des deux arbres (4, 6) à des distances angulaires identiques les uns par rapport aux autres, dans lequel la périodicité d'un agencement symétrique de rotation des éléments de mesure sensibles au champ magnétique (20) est différente de la périodicité des anneaux polaires magnétiques (10, 12).

2. Système de capteur selon la revendication 1, dans lequel des pôles des éléments magnétiques (29, 48, 50) sont disposés de manière orientée en direction radiale sur chaque arbre (4, 6, 42, 44).

3. Système de capteur selon la revendication 1 ou 2, dans lequel deux éléments magnétiques (29, 48, 50) disposés côte à côte sur un arbre (4, 6, 42, 44) sont en contact l'un avec l'autre et fournissent une transition (58) entre les pôles.

4. Système de capteur selon l'une des revendications précédentes, dans lequel chaque arbre (4, 6, 42, 44) présente le même nombre d'éléments magnétiques (29, 48, 50), dans lequel un champ magnétique (32) de chaque élément magnétique (29, 48, 50) présente la même intensité de champ et la même direction de champ.

5. Système de capteur selon l'une des revendications 2 à 4, pour lequel une position de base pour laquelle il est fait en sorte que les deux arbres (4, 6, 42, 44) soient tournés l'un par rapport à l'autre de 0° est définie, dans lequel des pôles identiques sont disposés le long d'une circonférence radiale des deux arbres (4, 6, 42, 44) à une position angulaire de x° sur le premier arbre (4) et sur le deuxième arbre (6).

6. Système de capteur selon l'une des revendications précédentes, dans lequel les éléments de mesure sensibles au champ magnétique (20, 56) sont disposés dans la direction axiale des deux arbres (4, 6, 42, 44), en position centrale entre les éléments magnétiques (29, 48, 50) disposés sur les deux arbres (4, 6, 42, 44).

7. Procédé de détermination d'une rotation relative de deux arbres (4, 6) disposés de manière coaxiale l'un par rapport à l'autre, comportant un système de capteur (2) qui comprend une pluralité d'éléments magnétiques (29) disposés sur un premier arbre (4) et une pluralité d'éléments magnétiques (29) disposés sur un deuxième arbre (6),
dans lequel les éléments magnétiques (29) qui sont disposés sur le premier arbre (4) forment un premier anneau polaire magnétique (10) et les éléments magnétiques (29) qui sont disposés sur le deuxième arbre (26) forment un deuxième anneau polaire magnétique (12),
dans lequel le système de capteur (2) comprend une pluralité d'éléments de mesure sensibles au champ magnétique (20) qui sont disposés en position fixe entre les éléments magnétiques (29) des deux arbres (4, 6), **caractérisé en ce que** la pluralité d'éléments de mesure sensibles au champ magnétique (20) sont disposés sur un cercle entourant l'axe de rotation commun des deux arbres (4, 6) à des distances angulaires identiques les uns par rapport aux autres, dans lequel la périodicité d'un agencement symétrique de rotation des éléments de mesure sensibles au champ magnétique (20) est différente de la périodicité des anneaux polaires magnétiques (10, 12), dans lequel un champ magnétique résultant de la superposition des champs magnétiques (32) des éléments magnétiques (29) des deux arbres (4, 6) est détecté par les éléments de mesure (20).

8. Procédé selon la revendication 7, dans lequel la rotation relative des deux arbres (4, 6, 42, 44) l'un par rapport à l'autre est déterminée à partir d'une variation du champ magnétique qui résulte de la superposition des champs magnétiques (32) des éléments magnétiques (29, 48, 50) des deux arbres (4, 6, 42, 44).
